# EUROPEAN PATENT APPLICATION

(11) **EP 2 362 426 A2**
(43) Date of publication of application: **31.08.2011**
(21) Application number: 11155255.0
(22) Date of filing: 21.02.2011
(51) Int. Cl.: H01L 31/0224, H01L 31/18

(54) **Photovoltaic cell substrate and photovoltaic cell including the same**

(30) Priority: 19.02.2010 KR 20100015150
(71) Applicant: Samsung Corning Precision Materials Co., Ltd., Gyeongsangbuk-do 730-735 (KR)
(72) Inventor: Kim, Jin-Seok, 336-841, Asan-si (KR); Yoo, Young Zo, 336-841, Asan-si (KR); Kim, Seo Hyun, 336-841, Asan-si (KR)
(74) Representative: Gulde Hengelhaupt Ziebig & Schneider

(57) **Abstract**

A photovoltaic cell substrate and a photovoltaic cell including the same are disclosed. The photovoltaic cell substrate includes a transparent substrate and a transparent conductive film formed over the transparent substrate. The transparent conductive film includes a zinc oxide thin film layer doped with a dopant, and both a (0002) growth plane and a **(101̅1)** growth plane are present in the zinc oxide thin film layer according to X-Ray Diffraction (XRD) data.

## Description

### CROSS REFERENCE TO RELATED APPLICATION

The present application claims priority from Korean Patent Application Number 10-2010-0015150 filed on February 19, 2010, the entire contents of which application are incorporated herein for all purposes by this reference.

### BACKGROUND OF THE INVENTION

### Field of the Invention

The present invention relates to a photovoltaic cell substrate and a photovoltaic cell including the same.

### Description of Related Art

A photovoltaic cell is a key element in the solar power generation, in which energy from sunlight is converted directly into electricity. Photovoltaic cells are applied in various fields, including electrical and electronic appliances, the supply of electrical power to houses and buildings, and industrial power generation. The most basic structure of the photovoltaic cell is a p-n junction diode. Photovoltaic cells are classified, according to the material that is used in the light absorbing layer, into: a silicon photovoltaic cell, which uses silicon as the light absorbing layer; a compound photovoltaic cell, which uses Copper Indium Diselenide (CIS: CuInSe₂), Cadmium Telluride (CdTe), etc. as the light absorbing layer; a dye-sensitized photovoltaic cell, in which photosensitive dye particles, which activate electrons by absorbing visible light, are adsorbed on the surface of nanoparticles of a porous film; a tandem photovoltaic cell. In addition, photovoltaic cells can be classified into bulk photovoltaic cells and thin film photovoltaic cells.

At present, bulk polycrystalline silicon photovoltaic cells occupy 90% or more of the market. However, power generation using bulk polycrystalline silicon photovoltaic cells is three to ten times as expensive as existing power generation such as thermal power generation, nuclear power generation, or hydraulic power generation. This is mainly attributable to expensive polycrystalline silicon and the high manufacturing cost of bulk polycrystalline silicon photovoltaic cells, which is complicated to manufacture. Therefore, in recent days, thin-film amorphous silicon (a-Si:H) photovoltaic cells and thin-film microcrystalline silicon (µc-Si:H) photovoltaic cells are being actively studied and commercially distributed.

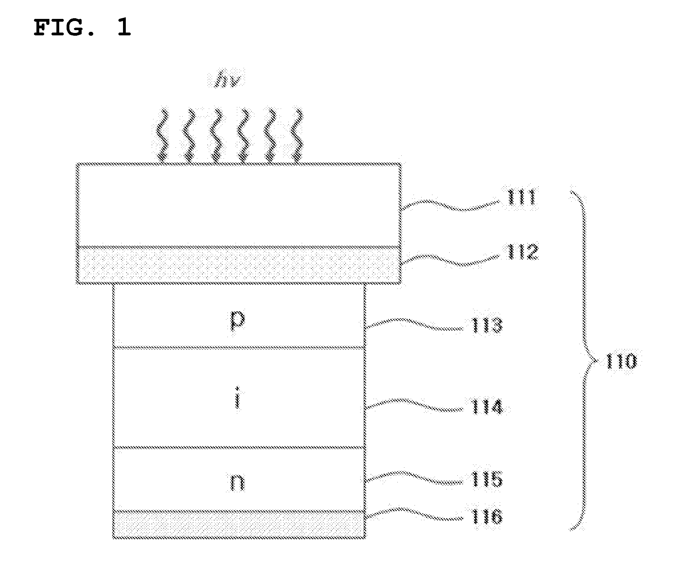

FIG. 1 is a cross-sectional view showing the structure of a photovoltaic cell 110 of the related art which uses amorphous silicon as a light-absorbing layer.

As shown in FIG. 1, the conventional amorphous silicon (e.g., a-Si:H) photovoltaic cell 110 includes a transparent substrate 111, a transparent conductive film 112, a p-type amorphous silicon (a-Si:H) layer 113, which is doped with a dopant, an intrinsic amorphous silicon (a-Si:H) layer 114, which is not doped with a dopant, an n-type amorphous silicon (a-Si:H) layer 115, which is doped with a dopant, and a back reflector 116. In this p-i-n type amorphous silicon (a-Si:H) structure, the intrinsic amorphous silicon (a-Si:H) layer 114 is subject to depletion by the p-type and n-type amorphous silicon (a-Si:H) layers 113 and 115 such that an electric field is created therein. When an electron-hole pair is formed in the intrinsic amorphous silicon (a-Si:H) layer 114 in response to incident light (hv), it drifts due to the internal electrical field and is then collected by the p-type amorphous silicon (a-Si:H) layer 113 and the n-type amorphous silicon (a-Si:H) layer 115, thereby generating electrical current.

Microcrystalline silicon (µc-Si : H) is an intermediate between single crystalline silicon and amorphous silicon, and has a grain size ranging from tens to hundreds of nanometers. At the grain boundary, an amorphous phase is frequently present and, in most cases, carrier recombination occurs due to its high density of defects. Microcrystalline silicon (µc-Si:H) has an energy band gap of about 1.6eV, which is not significantly different from that of single crystalline silicon (about 1.12Ev), and does not exhibit such deterioration as occurs in the amorphous silicon (a-Si:H) photovoltaic cell. The structure of the microcrystalline silicon (µc-Si:H) photovoltaic cell is very similar to that of the amorphous silicon (a-Si:H) photovoltaic cell, except for the light absorbing layer.

A single p-i-n junction thin film photovoltaic cell which uses amorphous silicon (a-Si:H), microcrystalline silicon (µc-Si:H), etc. as the light absorbing layer, has low light conversion efficiency, which imposes many restrictions on its practical use. Therefore, a tandem (multi-junction) photovoltaic cell is introduced, which is fabricated by multi-stacking the amorphous silicon (a-Si:H) photovoltaic cell units, the microcrystalline silicon (µc-Si:H) photovoltaic cell units, etc. The tandem photovoltaic cell has such structure that the photovoltaic cell units are connected in series and thereby can increase open circuit voltage and improve the light conversion efficiency.

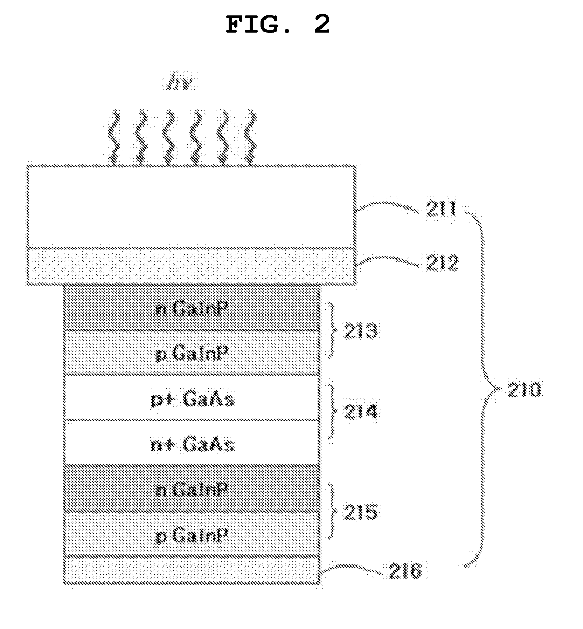

FIG. 2 is a cross-sectional view showing the structure of a tandem photovoltaic cell 210 of the related art.

As shown in FIG. 2, the tandem photovoltaic cell 210 of the related art generally includes a transparent substrate 211, a transparent conductive film 212, a first p-n junction layer 213, a tunneling p-n junction layer 214, a second p-n junction layer 215, and a back reflector 216.

In the tandem photovoltaic cell 210 of the related art, the first p-n junction layer 213, having a predetermined band gap (e.g., E*_{g}* 1.6eV), is disposed above the second p-n junction layer 215, which has a smaller band gap (e.g., E*_{g}*=1.1eV), such that a photon having an energy of 1.1eV<*h*v<1.6eV is allowed to pass through the first p-n junction layer 213 but is absorbed by the second p-n junction layer 215. It is possible to realize higher light conversion efficiency by increasing the number of p-n junction layers that are stacked in the tandem photovoltaic cell.

The transparent conductive film used in the photovoltaic cell is required to exhibit excellent light transmittance, electrical conductivity, and light trapping efficiency. In particular, in the case of the tandem thin film photovoltaic cell, the transparent conductive film is required to show high light transmittance and a high haze value over a wide wavelength band ranging from 400nm to 1100nm. In addition, while the transparent conductive film is deposited, it is also required to withstand hydrogen plasma.

The popular transparent conductive film for photovoltaic cell applications contains tin oxide (SnO₂) as a main ingredient. However, this type of transparent conductive film suffers from deterioration due to hydrogen plasma when it is deposited through Plasma Enhanced Chemical Vapor Deposition (PECVD). In addition, Indium Tin Oxide (ITO), which is generally used for existing transparent conductive films, has problems related to the continuously rising price of the main ingredient, indium (In), which is a rare element, the high reducibility of indium during the hydrogen plasma process and resultant chemical instability, and the like.

Therefore, studies are underway toward the development of a transparent conductive film that can replace the transparent film having SnO₂ or ITO as its main ingredient. Zinc oxide (ZnO) is the material that is recently gaining attention as the most ideal material. Since zinc oxide can be easily doped and has a narrow conduction band, it is easy to control the electrical-optical properties of zinc oxide depending on the type of dopant. In addition, the transparent conductive film having zinc oxide as a main ingredient is stable when subjected to the hydrogen plasma process, can be fabricated at low cost, and exhibits high light transmittance and high electrical conductivity.

Although zinc oxide (ZnO) has merits in that its electrical conductivity and optical properties can be easily adjusted by controlling the dopant, it has a disadvantage in that it is vulnerable to heat. Zinc oxide is required to exhibit thermal stability, since a light-absorbing layer, which contains Si, Copper Indium Gallium Selenide (CIGS), or Cadmium Telluride (CdTe) as a main ingredient, has to be formed over the transparent conductive film. In general, high temperature is required in order to form the light-absorbing layer over the transparent conductive film. Accordingly, zinc oxide, which is the main ingredients of the transparent conductive film, is required to efficiently withstand high temperatures without exhibiting deterioration in performance, such as the increase in resistance or the decrease in light transmittance.

The information disclosed in this Background of the Invention section is only for the enhancement of understanding of the background of the invention, and should not be taken as an acknowledgment or any form of suggestion that this information forms a prior art that would already be known to a person skilled in the art.

### BRIEF SUMMARY OF THE INVENTION

Various aspects of the present invention provide a photovoltaic cell substrate having excellent heat resistance and a photovoltaic cell including the same photovoltaic cell substrate.

Also provided are a photovoltaic cell having high photoelectric conversion efficiency and a photovoltaic cell including the same photovoltaic cell substrate.

In an aspect of the present invention, the photovoltaic cell substrate includes a transparent substrate and a transparent conductive film formed over the transparent substrate. The transparent conductive film includes a zinc oxide thin film layer doped with a dopant, and both a (0002) growth plane and a (101̅1) growth plane are present in the zinc oxide thin film layer according to X-Ray Diffraction (XRD) data.

In the sense of the present invention, the presence of a (0002) growth plane and a **(101̅1)** growth plane is understood in that the intensity of the X-Ray Diffraction (XRD) data signal of each of the (0002) growth plane and the **(101̅1)** growth plane is significantly (preferably two times, more preferably ten times) higher than the average intensity of the signal noise.

Preferably a peak intensity of the **(101̅1)** growth plane is greater than or equal to that of the (0002) growth plane according to the X-ray diffraction data.

Preferably, after heat treatment for heat resistance test of the transparent conductive film, a peak intensity of the **(101̅1)** growth plane is greater than or equal to that of the (0002) growth plane according to the X-ray diffraction data.

Preferably the dopant added to zinc oxide is at least one selected from among Al, Ga, In, Ti, and B.

Preferably the transparent conductive film further includes an impurity elution preventing film formed between the transparent substrate and the zinc oxide thin film, the impurity elution preventing film preventing impurity from being eluted from inside the transparent substrate.

Preferably the impurity elution preventing film is made of silicon oxide (SiO₂) or titanium oxide (TiO₂) .

In an aspect of the present invention, a photovoltaic cell comprising a photovoltaic cell substrate, wherein the photovoltaic cell substrate comprises: a transparent substrate; and a transparent conductive film formed over the transparent substrate, wherein the transparent conductive film includes a zinc oxide thin film layer doped with a dopant, wherein both a (0002) growth plane and a **(101̅1)** growth plane are present in the zinc oxide thin film layer according to X-ray diffraction data.

Preferably the photovoltaic cell comprises one selected from among a tandem photovoltaic cell, a compound photovoltaic cell, and a dye-sensitized photovoltaic cell.

The photovoltaic cell substrate as set forth above is not subject to deterioration in performance, such as the increase in resistance or the decrease in light transmittance, at high temperatures when a light-absorbing layer is formed thereover.

The methods and apparatuses of the present invention have other features and advantages which will be apparent from, or are set forth in more detail in the accompanying drawings, which are incorporated herein, and in the following Detailed Description of the Invention, which together serve to explain certain principles of the present invention.

### BRIEF DESCRIPTION OF THE DRAWINGS

FIG. 1 is a cross-sectional view showing the structure of a photovoltaic cell of the related art which uses amorphous silicon as a light-absorbing layer;

FIG. 2 is a cross-sectional view showing the structure of a tandem photovoltaic cell of the related art;

FIG. 3 is a flowchart showing a method of fabricating a photovoltaic cell substrate according to an exemplary embodiment of the invention;

FIG. 4 is a cross-sectional view showing the structure of a photovoltaic cell substrate, which is fabricated by the method of fabricating a photovoltaic cell substrate according to an exemplary embodiment of the invention;

FIG. 5 is graphs showing X-Ray Diffraction (XRD) patterns of a photovoltaic cell substrate before and after heat treatment; and

FIG. 6 is a graph showing the light transmittance versus wavelength of a photovoltaic cell substrate before and after heat treatment.

### DETAILED DESCRIPTION OF THE INVENTION

Reference will now be made in detail to various embodiments of the present invention, examples of which are illustrated in the accompanying drawings and described below. While the invention will be described in conjunction with exemplary embodiments, it will be understood that the present description is not intended to limit the invention to those exemplary embodiments. On the contrary, the invention is intended to cover not only the exemplary embodiments, but also various alternatives, modifications, equivalents and other embodiments that may be included within the scope of the invention as defined by the appended claims.

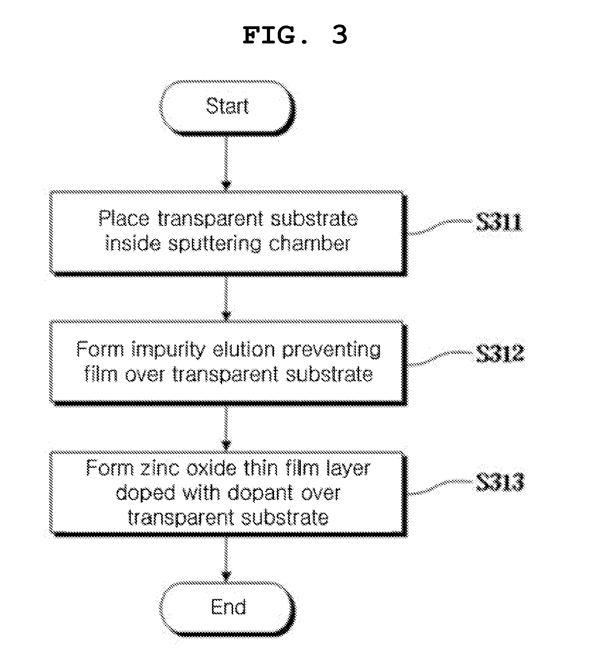

FIG. 3 is a flowchart showing a method of fabricating a photovoltaic cell substrate according to an exemplary embodiment of the invention.

As shown in FIG. 3, the method of fabricating a photovoltaic cell substrate of this embodiment includes the step of placing a transparent substrate inside a sputtering chamber (step S311). A sputtering target made of a material to be deposited over the transparent substrate is mounted inside the sputtering chamber.

Afterwards, an impurity elution preventing film is formed over the transparent substrate at S312. The impurity elution preventing film serves to prevent impurity from being eluted from the inside of the transparent substrate. In an example, the impurity elution preventing film can be made of silicon oxide (SiO₂) or titanium oxide (TiO₂).

Afterwards, at S313, a zinc oxide (ZnO) thin film layer doped with a dopant is formed over the transparent substrate, which is placed inside the sputtering chamber. In general, in order to grow a thin film layer made of zinc oxide with a (0002) growth plane or a **(101̅1)** growth plane, a long mean free path is required. The mean free path indicates the distance that particles, which move from the sputtering target to the transparent substrate, can freely travel without colliding with other particles inside the chamber. In the meantime, as surface migration, in which particles, which have moved over the transparent substrate, are caused to move by the temperature of the transparent substrate, is greater, the probability that the (0002) growth plane might be formed increases.

Therefore, in order to lower the surface migration while increasing the mean free path, at the step S313 of forming a zinc oxide thin film layer doped with a dopant over the transparent substrate, it is preferred that the pressure inside the sputtering chamber be maintained in the range from from 1mTorr to 50mTorr and the temperature of the transparent substrate is preferably maintained in the range from 200°C to 300°C. In an example, the dopant added to zinc oxide may include at least one selected from among aluminum (Al), gallium (Ga), indium (In), titanium (Ti), and boron (B).

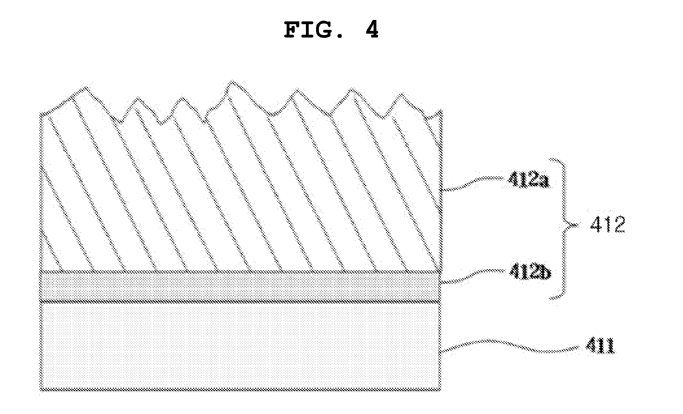

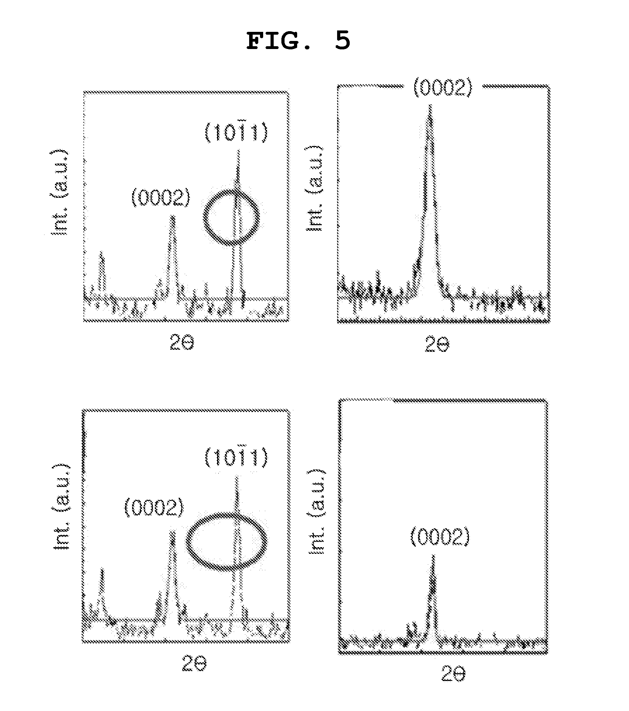

FIG. 4 is a cross-sectional view showing the structure of a photovoltaic cell substrate according to an exemplary embodiment of the invention, and FIG. 5 is graphs showing X-Ray Diffraction (XRD) patterns of the photovoltaic cell substrate before and after heat treatment for a heat resistance test to examine whether the photovoltaic cell substrate can endure a thermal condition of a subsequent manufacturing process of the photovoltaic cell.

First, as shown in FIG. 4, the photovoltaic cell substrate includes a transparent substrate 411 and a transparent conductive film 412. The transparent conductive film 412 includes a zinc oxide (ZnO) thin film layer 412a doped with a dopant.

The transparent substrate 411 can be a sheet of glass which has a thickness of 5mm or less and a light transmittance of 90% or more. In another example, the transparent substrate 411 can be a heat curing or Ultraviolet (UV) curing organic film which is generally made of a polymer-based material. Examples of the polymer-based material may include Polyethylene Terephthalate (PET), acryl, Polycarbonate (PC), Urethane Acrylate (UA), polyester, Epoxy Acrylate (EA), brominate acrylate, Polyvinyl Chloride (PVC), and the like.

The transparent conductive film 412 allows an electrical current, generated by photoelectric conversion, to pass through. The transparent conductive film 412 is formed over the transparent substrate 411, and includes the zinc oxide thin film layer 412a doped with a dopant. Since the electrical properties of zinc oxide are very similar to those of insulators, zinc oxide needs to be doped with a dopant in order to have electrical conductivity. Here, the dopant in the zinc oxide can include at least one selected from among aluminum (Al), gallium (Ga), indium (In), titanium (Ti), and boron (B). In an example, the zinc oxide may be co-doped with two or more dopants. It is preferred that the dopant in zinc oxide be Ga or Al, which has relatively excellent moisture resistance.

In general, in order to form a light-absorbing layer which contains Si, Copper Indium Gallium Selenide (CIGS), or Cadmium Telluride (CdTe) as a main ingredient, over the transparent conductive film 412, a heating temperature that is high, for example, ranges from 250°C to 600°C, is required. Therefore, the zinc oxide thin film layer 412a of the transparent conductive film 412 is required to exhibit heat resistance such that it can withstand such high temperatures without any deterioration in performance, such as the increase in resistance or the decrease in light transmittance.

It is preferred that the zinc oxide thin film layer 412a have both a (0002) growth plane and a **(101̅1)** growth plane according to XRD data. The atomic planar density of the **(101̅1)** crystal plane is smaller than that of the (0002) crystal plane, according to the structure of zinc oxide. Accordingly, when a dopant is doped and substitutes a zinc atom, it is located in the **(101̅1)** crystal plane, which has a smaller atomic planar density. As a result, the magnitude of tension occurred is relatively smaller than that of a zinc oxide thin film layer which has only the (0002) growth plane. In addition, intrinsic defects that occur in the structure of zinc oxide in order to compensate the tension are fewer. That is, the zinc oxide thin film layer 412a in which both the (0002) growth plane and the **(101̅1)** growth plane are present, are not vulnerable to heat.

In an example, the zinc oxide thin film layer 412a can be formed through a sputtering process in which the temperature of the transparent substrate 411 ranges from 200°C to 300°C, and the pressure inside the sputtering chamber ranges from 1mTorr to 50mTorr.

In the zinc oxide thin film layer 412, it is preferred that, after heat treatment for the heat resistance test of the transparent conductive film, the peak intensity of the **(101̅1)** growth plane be the same as or greater than that of the (0002) growth plane, according to the XRD data.

Table 1 below shows changes in XRD intensity peak before and after the heat resistance test of a photovoltaic cell substrate as shown in FIG. 4.

**Table 1**

| | XRD Int. **(101̅1)** /(0002) ratio | | Change in (0002) XRD Int. peak | | HRC** |
|---|---|---|---|---|---|
| | Before HRT* | After HRT* | Before HRT* | After HRT* | |
| Example | 1.6 | 1.6 | 47.1 | 47.0 | Good |
| Comp. Ex. | 0 | 0 | 86.3 | 32.0 | Poor |

| | | | | | |
|---|---|---|---|---|---|
| Note) HRT*: heat resistance test, HRC**: heat resistance characteristic | | | | | |

In Table 1, the peak intensity of the **(101̅1)** growth plane was 75.4, which was constant before and after the heat resistance test. The dopant added to zinc oxide was Al, and heat resistance was tested through heat treatment in a heat treatment chamber at a temperature of 500°C for 5 minutes. The heat treatment was performed through Rapid Thermal Annealing (RTA). Heat resistance was determined through XRD measurement, based on formation/disappearance of a crystal plane or changes in the peak intensity of the crystal plane before and after heat treatment.

As shown in Table 1 above, in the Example of the present invention, a transparent conductive film was manufactured by sputtering, in which the temperature was 200°C and the pressure inside the chamber was 30mTorr.

Heat resistance was determined to be excellent. FIG. 5(A) shows an XRD pattern for the photovoltaic cell substrate according to the Example before heat treatment, and FIG. 5(B) shows an XRD pattern for the photovoltaic cell substrate according to the Example after heat treatment. As shown in FIG. 5(A) and FIG. 5(B), peak intensities of (0002) and **(101̅1)** crystal planes of Al-doped zinc oxide did not change, and no new crystal plane formed.

FIG. 5 (C) and FIG. 5 (D) show XRD patterns of the photovoltaic cell substrate according to the Comparative Example before and after heat treatment. In the Comparative Example, a transparent conductive film was manufactured at a temperature of 350°C by Atmospheric Pressure Chemical Vapor Deposition (APCVD).

As shown in FIG. 5(D), the heat resistance of the photovoltaic cell substrate according to the Comparative Example was determined to be bad. In the Comparative Example, according to XRD measurement, only the (0002) crystal plane was present before heat treatment, and the peak intensity of the (0002) crystal plane decreased after heat treatment.

As shown in FIG. 4, the transparent conductive film 412 may also include the impurity elution preventing film 412b. The impurity elution preventing film 412b is formed between the transparent substrate 411 and the zinc oxide thin film layer 412a. The impurity elution preventing film 412b serves to prevent impurity, for example, alkali ions such as sodium ions (Na⁺) from being eluted from the inside of the transparent substrate made of, for example, soda lime glass (SiO₂-CaO-Na₂O) or aluminosilicate glass (SiO₂-Al₂O₃-Na₂O) . It is preferred that the impurity elution preventing film 412b be made of silicon oxide (SiO₂) or titanium oxide (TiO₂). The refractive index of the impurity elution preventing film 412b can be matched with that of the transparent substrate 411 by adjusting the thickness of the film 412b. Accordingly, the impurity elution preventing film 412b can prevent incident light from being reflected from the surface of the transparent substrate 411.

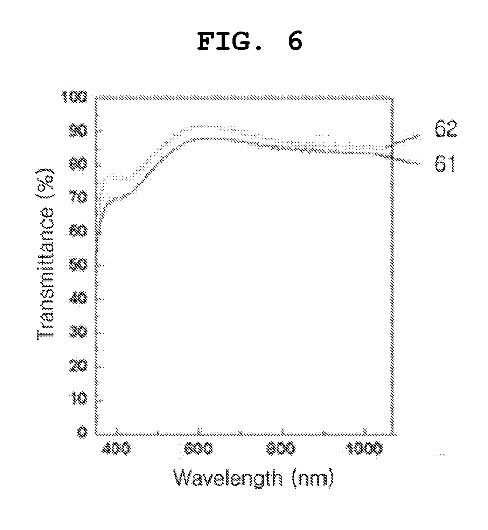

FIG. 6 is a graph showing the light transmittance versus wavelength of a photovoltaic cell substrate according to an exemplary embodiment of the invention before and after heat treatment. Here, the light transmittance was the average transmittance which was calculated by measuring spectral transmittance in the range from 380nm to 1100nm using a Lambda-950 spectrophotometer.

In FIG. 6, reference numeral 61 denotes a curve of light transmittance before heat treatment, and reference numeral 62 denotes a curve of light transmittance after heat treatment. Referring to the curve of light transmittance designated by reference numeral 62, it can be appreciated that light transmittance in a wavelength range from 500nm to 1100nm is 80% or more.

The foregoing descriptions of specific exemplary embodiments of the present invention have been presented for the purposes of illustration and description. They are not intended to be exhaustive or to limit the invention to the precise forms disclosed, and obviously many modifications and variations are possible in light of the above teachings. The exemplary embodiments were chosen and described in order to explain certain principles of the invention and their practical application, to thereby enable others skilled in the art to make and utilize various exemplary embodiments of the present invention, as well as various alternatives and modifications thereof. It is intended that the scope of the invention be defined by the claims appended hereto and their equivalents.

## Claims

1. A photovoltaic cell substrate comprising:
a transparent substrate (411); and
a transparent conductive film (412) formed over the transparent substrate (411), wherein the transparent conductive film (412) comprises a zinc oxide thin film layer (412a) doped with a dopant,
wherein both a (0002) growth plane and a **(101̅1)** growth plane are present in the zinc oxide thin film layer (412a) according to X-ray diffraction data.

2. The photovoltaic cell substrate according to claim 1, wherein, after heat treatment for heat resistance test of the transparent conductive film, a peak intensity of the **(101̅1)** growth plane is greater than or equal to that of the (0002) growth plane according to the X-ray diffraction data.

3. The photovoltaic cell substrate according to any one of the preceding claims, wherein the dopant added to zinc oxide is at least one selected from among Al, Ga, In, Ti, and B.

4. The photovoltaic cell substrate according to any one of the preceding claims, wherein the transparent conductive film (412) further comprises an impurity elution preventing film (412b) formed between the transparent substrate (411) and the zinc oxide thin film (412a), the impurity elution preventing film (412b) being adapted to prevent impurities from being eluted from inside the transparent substrate (411).

5. The photovoltaic cell substrate according to any one of the preceding claims, wherein the impurity elution preventing film is made of silicon oxide (SiO₂) or titanium oxide (TiO₂) .

6. A photovoltaic cell comprising a photovoltaic cell substrate (412, 411) according to any one of the preceding claims.

7. The photovoltaic cell according to claim 6, comprising one selected from among a tandem photovoltaic cell, a compound photovoltaic cell, and a dye-sensitized photovoltaic cell.
